# EUROPEAN PATENT APPLICATION

(11) **EP 4 745 759 A1**
(43) Date of publication of application: **20.05.2026**
(21) Application number: 25216254.0
(22) Date of filing: 17.11.2025
(51) Int. Cl.: G06F 8/33, G06F 8/34, G05B 19/05

(54) **INLINE ARTIFICIAL INTELLIGENCE TOOL FOR GRAPHICAL OBJECT PROGRAMMING**

(30) Priority: 18.11.2024 US 202463721921 P; 21.10.2025 US 202519365122
(71) Applicant: Rockwell Automation Technologies, Inc., Mayfield Heights, OH 44124 (US)
(72) Inventor: Carrara, Anthony, Mayfield Heights, OH, 44124 (US); Fernandes, Fabiano, Mayfield Heights, OH, 44124 (US); Adamczak, Ewelina, Mayfield Heights, OH, 44124 (US); Grajales Alzate, Anderson D., Mayfield Heights, OH, 44124 (US); Pantea, Adrian D., Mayfield Heights, OH, 44124 (US); Hays, Christopher S., Mayfield Heights, OH, 44124 (US); Ohlsen, Michael J., Mayfield Heights, OH, 44124 (US)
(74) Representative: Grünecker Patent- und Rechtsanwälte PartG mbB

(57) **Abstract**

A method may include receiving a request to generate graphical object programming code via design environment comprising a plurality of lines for coding. The method may also include presenting an inline visualization corresponding a first line of the plurality of lines, receiving an input comprising a natural language description of one or more operations for the graphical object programming code within the inline visualization, and generating the graphical object programming code within the inline visualization based on the input and one or more large language models (LLMs). The method may also involve presenting the graphical object programming code within the inline visualization.

## Description

### CROSS REFERENCE TO RELATED APPLICATIONS

This application claims priority to and the benefit of U.S. Patent Application No. 63/721,921, entitled "INLINE ARTIFICIAL INTELLIGENCE TOOL FOR GRAPHICAL OBJECT PROGRAMMING", filed November 18, 2024, which is herein incorporated by reference in its entirety for all purposes.

### BACKGROUND

This disclosure generally relates to industrial automation systems and, more particularly, to providing an artificial intelligence (Al) tool for generating programming parameters for an industrial tool in an industrial system.

Design of industrial automation systems may involve a designer or controls engineer generating projects of programmatic code defining respective functions and roles for each device and/or object within the industrial automation system. The project of programmatic code may include lines of code that depend on each other and/or build off one another (e.g., an output of one line of code may act as an input for another line of code) to define relationships (e.g., inputs/outputs) between devices and their respective functions in the industrial automation system. As individuals use various coding systems to define functions and projects, improved techniques to view and generate programmatic code may be desired.

This section is intended to introduce the reader to various aspects of art that may be related to various aspects of the present techniques, which are described and/or claimed below. This discussion is believed to be helpful in providing the reader with background information to facilitate a better understanding of the various aspects of the present disclosure. Accordingly, it should be understood that these statements are to be read in this light, and not as admissions of prior art.

### BRIEF DESCRIPTION

A summary of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects that may not be set forth below.

A method may include receiving a request to generate graphical object programming code via design environment comprising a plurality of lines for coding. The method may also include presenting an inline visualization corresponding a first line of the plurality of lines, receiving an input comprising a natural language description of one or more operations for the graphical object programming code within the inline visualization, and generating the graphical object programming code within the inline visualization based on the input and one or more large language models (LLMs). The method may also involve presenting the graphical object programming code within the inline visualization.

### BRIEF DESCRIPTION OF THE DRAWINGS

These and other features, aspects, and advantages of the present disclosure will become better understood when the following detailed description is read with reference to the accompanying drawings in which like characters represent like parts throughout the drawings, wherein:
FIG. 1 is a schematic view of an operational technology (OT) environment, in accordance with an embodiment;
FIG. 2 is a block diagram of example components that could be used in a computing system of FIG. 1, in accordance with an embodiment;
FIG. 3 illustrates a flow chart of a method for providing graphical object programming code using large language models, in accordance with an embodiment;
FIG. 4 illustrates an example visualization for generating graphical object programming code for an industrial automation system, in accordance with aspects of the present disclosure;
FIG. 5 illustrates a flowchart of a method for providing inline input visualizations for generating graphical object programming code, in accordance with aspects of the present disclosure;
FIG. 6 illustrates an example visualization for initiating an inline input visualization for generating graphical object programming code, in accordance with aspects of the present disclosure;
FIG. 7 illustrates an example visualization for providing an input to an inline input visualization for generating graphical object programming code, in accordance with aspects of the present disclosure;
FIG. 8 illustrates an example visualization for graphical object programming code generating with an inline input visualization, in accordance with aspects of the present disclosure;
FIG. 9 illustrates a flowchart of a method for generating test scripts to verify the operability of graphical object programming code, in accordance with aspects of the present disclosure;
FIG. 10 illustrates a flow chart of a method for generating real-time graphical object programming code based on real-time data analysis, in accordance with embodiments presented herein;
FIG. 11 illustrates an example visualization for generating graphical object programming code for sequential function chart (SFC), in accordance with aspects of the present disclosure; and
FIG. 12 illustrates an example visualization for generating graphical object programming code for function block diagram (FBD), in accordance with aspects of the present disclosure.

### DETAILED DESCRIPTION

One or more specific embodiments of the present disclosure will be described below. In an effort to provide a concise description of these embodiments, all features of an actual implementation may not be described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the present disclosure, the articles "a," "an," "the," and "said" are intended to mean that there are one or more of the elements. The terms "comprising," "including," and "having" are intended to be inclusive and mean that there may be additional elements other than the listed elements. Any examples of operating parameters and/or environmental conditions are not exclusive of other parameters/conditions of the disclosed embodiments.

As used herein, the term "computing system" refers to an electronic computing device such as, but not limited to, a single computer, virtual machine, virtual container, host, server, edge device, laptop, tablet, and/or mobile device, or to a plurality of electronic computing devices working together to perform the function described as being performed on or by the computing system. As used herein, the term "medium" refers to one or more non-transitory, computer-readable physical media that together store the contents described as being stored thereon. Embodiments may include non-volatile secondary storage, read-only memory (ROM), and/or random-access memory (RAM). As used herein, the term "application" refers to one or more computing modules, programs, processes, workloads, threads and/or a set of computing instructions executed by a computing system. Example embodiments of an application include software modules, software objects, software instances and/or other types of executable code.

The design of even relatively simple industrial automation systems involves a designer paying close attention to make sure various portions of code function properly with one another. Design environments or authoring tools (e.g., industrial automation software or applications) used to generate projects of programmatic code may include limited space to view and build out the projects. Thus, designers may only view a few lines of code at one time (e.g., 1-3 lines of code) and may spend a great deal of time scrolling through lines of programmatic code while generating or debugging the code to ensure various portions of code function properly with one another. Indeed, in some cases, design of industrial automation systems may involve generating programmatic code defining the logic controlling the system and defining the input/output relationships between industrial automation devices. A designer may interact with an authoring tool to generate a project of programmatic code by manually selecting components (e.g., devices, operators) they want to include in a system and defining connections between the components. For example, a designer may generate a project file using ladder logic to define routines, sub-routines, and the like, for a programmable logic controller (PLC) to implement within an industrial automation system.

Ladder logic may correspond to a graphical programming language that allows users to enter logic operators that define the operation of the PLC. Ladder logic diagrams include rungs (e.g., horizontal lines) and rails (e.g., vertical lines), such that each rung represents a set of conditions and actions. Each rung may include an instruction box (e.g., logic object) defining logical operators for each condition (e.g., input) and action (e.g., output), and the rails may define a start point and an end point for each rung. The PLC may execute the project file by reading the rungs from left to right between the rails and from top to bottom to control operations of one or more devices and/or processes within the industrial automation system based on the ladder logic. As control operations for various devices in an industrial system become more complex, the respective ladder logic employed to implement the control operations may become longer as more rungs are used to define conditions and actions associated with operating the various devices. Although portions of this disclosure describe the graphical object programming code being used as ladder logic, it should be noted that the embodiments described herein may be implemented for any suitable graphical object programming code such as sequential function chart (SFC), function block diagram (FBD), and the like.

In various cases in which a designer may write portions of programmatic code for each device and/or object within the industrial automation system, the designer may pay close attention to making sure the various portions of code to ensure that they properly function with one another. Though certain combinations of devices or objects may be used frequently together, when used in a particular industrial automation system, the designer writes code for each component as though they have never been used together before. Further, in existing design environments, the designer is free to use incompatible objects together, or form invalid connections between objects, without any warning that design actions taken may render the industrial automation system inoperable. This may result in the designer spending a great deal of time reviewing previous designs and/or specifications of candidate objects or devices. If a problem arises, the designer is left on his or her own to troubleshoot the programmatic code for the industrial automation system without any guidance as to what the issue is and how to resolve it. As a result of these factors, designers of industrial automation systems are a relatively small, highly trained, and highly experienced group making it difficult for others to effectively program various devices.

The present disclosure is directed towards techniques for displaying and modifying control logic (e.g., ladder logic) of industrial automation systems. In some embodiments, a human machine interface (HMI) system or computing system executing design environment software may use generative artificial intelligence (AI) algorithms to deliver precise and contextually relevant graphical programming objects for use in graphical programming languages, such as Ladder Logic, in response to user inquiries regarding the same. In some embodiments, the HMI system may employ a large language model is trained to recognize associations between user's requests related to controlling industrial devices, such as PLCs, and corresponding graphical programming objects, arrangements of the graphical programming objects, and the like to implement the respective control operations.

Keeping the foregoing in mind, the computing system may receive various types of inputs (e.g., multi-modal) requesting assistance with respect to designing or updating graphical object programming code. That is, the computing system may provide options for a designer to provide an input via a text-based input field, a data-based input field (e.g., data upload), a voice-based input, and the like. In some embodiments, the computing system may receive the input data and analyze the input data to determine a request related to the graphical object code that may be stored in a project file, presented on a display, and the like. That is, the computing system may enable designers to query project files stored on storage components (e.g., database) related to industrial automation design proposals, gather project insights related to the designs, and generate conversation or natural language responses that provide insight into the queries.

Indeed, in some embodiments, the computing system may receive input audio data that may include voice instructions that detail a request provided by the designer. In this way, the computing system may perform graphical object programming operations without input text or documentation to provide a hands-free and on-the-go option for graphical object programming. By way of operation, the computing system may continuously sample the audio surroundings to detect an activation word for phrase. As such, the designer may speak one or more requests that may be detected by the computing system, such that the computing system may respond with an answer to the requests. In this way, the interaction between the designer and the computing system is inviting and informal.

In some embodiments, the computing system (e.g., voice-augmented assistant) may be triggered from a chat panel visualization. In response, the computing system may provide visual, textual, and auditory cues that may support the user in responding to their request. In some embodiments, as the computing system may provide a response to the designer, the designer may speak to interrupt it. This way, if the designer recognized that the response is not relevant to their request or desired result, the designer may forego or stop the current output by the computing system and bring up another topic to discuss. After the designer exits or ends a session with the computing system, the computing system may generate a transcript of the conversation for reference. That is, the audibly received input, the generated graphical programming code output, dialogue outputs, and the like may be reproduced for the designer's view via a chat window visualization. In turn, the designer may enter additional requests into the chat window visualization to continue the conversation with the computing system that may have been previously conducted in an audible (e.g., voice) format.

As mentioned above, in some embodiments, the computing system may receive inputs in other formats such as a document upload (e.g., design specification, input/output (IO) map, Piping and Instrumentation Diagram (P&ID) diagram, etc.), the designer may upload the document to the computing system, which may use suitable LLM to interpret the document. Indeed, the computing system may summarize the uploaded document in a conversational format and upload the document, along with any related vectors within the document (e.g., corresponding to LLMs), for future reference via the LLM.

Keeping the foregoing in mind, in some embodiments, the computing system may also provide real-time generative artificial intelligence (AI) functions based on datasets available to the computing system via networks and the like. That is, the computing system, for example, may employ streaming capabilities to identify logical patterns in datasets and generate insights, alerts, and predictions in real-time based on datasets available to the computing system.

The collected datasets may include data acquired from a control system or other industrial device. The datasets may include historical data, static data (e.g., offline tags), and the like. In addition, the datasets may include audio, video, live data (e.g., from control system), and the like. Using an LLM Realtime application programming interface (API) support system, the computing system may mix or cross analyze the various types of data within the datasets to identify patterns with the data combined or alone.

For instance, the computing system may leverage the Large Language Model (LLM) to recognize the semantic understanding of the real time data and combine its analysis of the real time data with respect to other datasets from various sources to generate insights, alerts, and predictions in real-time. By way of example, audio and video data may be collected along with datasets from a control system to generate insights and recommendations using the LLM. In one embodiment, a mobile phone device may collect audio and video data surrounding an industrial device. In another embodiment, a dedicated industrial device with this capability may collect the audio and video data. In any case, the AI component may augment programming design and operational tools (e.g., FactoryTalk Design Studio) to stream and receive the data. The Al component, which may be linked with logic and live data output by other industrial devices, may may provide a unique semantic meaning and understanding about the logical analysis related to the collected datasets and the physical aspect of the application, such as an arrangement of equipment, sections, actuators, motors, valves, instrumentation, sensors, and the like.

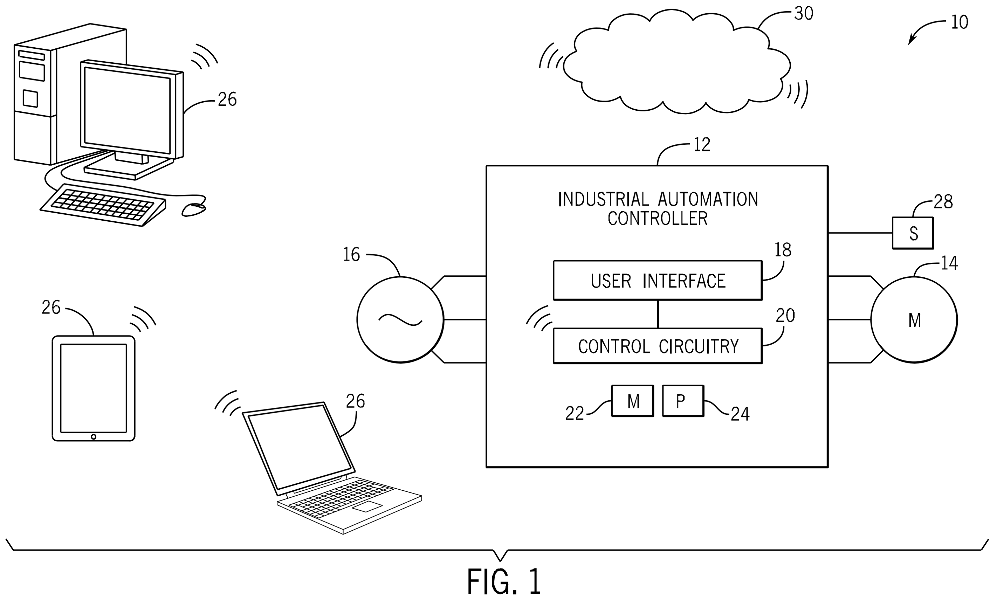

By way of introduction, FIG. 1 is a schematic view of an example operation technology (OT) environment 10 in which the embodiments described herein may be implemented. As shown, the OT environment 10 is an industrial automation system that includes a controller 12 (e.g., programmable logic controller) and a motor 14 (e.g., a load device). The OT environment 10 may also include a power source 16. The power source 16 may include a generator, an external power grid, a battery, or some other source of power. The controller 12 may be a stand-alone control unit that controls multiple industrial automation components (e.g., a plurality of motors 14), a controller 12 that controls the operation of a single automation component (e.g., motor 14), or a subcomponent within a larger OT environment 10. In the instant embodiment, the controller 12 includes a user interface 18, such as a human machine interface (HMI), and control circuitry 20 which may include a memory 22 and a processor 24. The controller 12 may include a cabinet or some other enclosure for housing various components of the OT environment 10, such as a motor starter, a disconnect switch, etc.

The control circuitry 20 may be programmed (e.g., via computer readable code or instructions stored on the memory 22, such as a non-transitory computer readable medium, and executable by the processor 24) to provide signals for controlling the motor 14. In certain embodiments, the control circuitry 20 may be programmed according to a specific configuration desired for a particular application. For example, the control circuitry 20 may be programmed to respond to external inputs, such as reference signals, alarms, command/status signals, etc. The external inputs may originate from one or more relays or other electronic devices. The programming of the control circuitry 20 may be accomplished through software or firmware code that may be loaded onto the internal memory 22 of the control circuitry 20 (e.g., via a locally or remotely located computing system 26) or programmed via the user interface 18 of the controller 12. The control circuitry 20 may respond to a set of operating parameters. The settings of the various operating parameters may determine the operating characteristics of the controller 12. For example, various operating parameters may determine the speed or torque of the motor 14 or may determine how the controller 12 responds to the various external inputs. As such, the operating parameters may be used to map control variables within the controller 12 or to control other devices communicatively coupled to the controller 12. These variables may include, for example, speed presets, feedback types and values, computational gains and variables, algorithm adjustments, status and feedback variables, programmable logic controller (PLC) control programming, and the like.

In some embodiments, the controller 12 may be communicatively coupled to one or more sensors 28 for detecting operating temperatures, voltages, currents, pressures, flow rates, and other measurable variables (e.g., real-time data) associated with the OT environment 10. With feedback data from the sensors 28, the control circuitry 20 may keep detailed track of the various conditions under which the OT environment 10 may be operating. For example, the feedback data may include conditions such as actual motor speed, voltage, frequency, power quality, alarm conditions, etc. In some embodiments, the feedback data may be communicated back to the computing system 26 for additional analysis.

The computing system 26 may be communicatively coupled to the controller 12 via a wired or wireless connection. The computing system 26 may receive inputs from a user defining an industrial automation project using a native application running on the computing system 26 or using a website accessible via a browser application, a software application, or the like. The user may define the industrial automation project by writing code (e.g., graphical object programming), interacting with a visual programming interface, inputting or selecting values via a graphical user interface, or providing some other inputs. The user may use licensed software and/or subscription services to create, analyze, and otherwise develop the project. The computing system 26 may send a project to the controller 12 for execution. Execution of the industrial automation project causes the controller 12 to control components (e.g., motor 14) within the OT environment 10 through performance of one or more tasks and/or processes. In some applications, the controller 12 may be communicatively positioned in a private network and/or behind a firewall, such that the controller 12 does not have communication access outside a local network and is not in communication with any devices outside the firewall, other than the computing system 26. The controller 12 may collect feedback data during execution of the project, and the feedback data may be provided back to the computing system 26 for analysis. Feedback data may include, for example, one or more execution times, one or more alerts, one or more error messages, one or more alarm conditions, one or more temperatures, one or more pressures, one or more flow rates, one or more motor speeds, one or more voltages, one or more frequencies, and so forth. The project may be updated via the computing system 26 based on the analysis of the feedback data.

The computing system 26 may be communicatively coupled to a cloud server 30 or remote server via the internet, or some other network. In one embodiment, the cloud server 30 may be operated by the manufacturer of the controller 12, a software provider, a seller of the controller 12, a service provider, operator of the controller 12, owner of the controller 12, and the like. The cloud server 30 may be used to help designers create and/or modify projects, to help troubleshoot any problems that may arise with the controller 12, develop policies, or to provide other services (e.g., project analysis, enabling, restricting capabilities of the controller 12, data analysis, controller firmware updates, etc.). The remote/cloud server 30 may be one or more servers operated by the manufacturer, software provider, seller, service provider, operator, or owner of the controller 12. The remote/cloud server 30 may be disposed at a facility owned and/or operated by the manufacturer, software provider, seller, service provider, operator, or owner of the controller 12. In other embodiments, the remote/cloud server 30 may be disposed in a datacenter in which the manufacturer, software provider, seller, service provider, operator, or owner of the controller 12 owns or rents server space. In further embodiments, the remote/cloud server 30 may include multiple servers operating in one or more data center to provide a cloud computing environment.

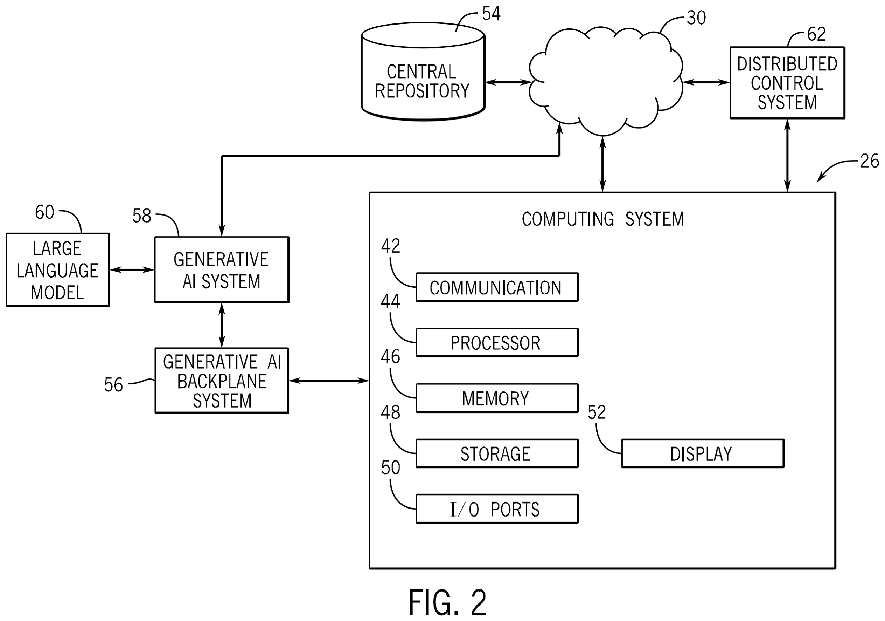

FIG. 2 illustrates a block diagram of example components the computing system 26, the cloud/remote server 30, the controller 12, or some other computing device provided by the present disclosure. As used herein, the computing system 26 may be implemented as one or more computing systems including laptop, notebook, desktop, tablet, HMI, or workstation computers, as well as server type devices or portable, communication type devices, such as cellular telephones and/or other suitable computing devices.

Referring now to FIG. 2, the computing system 26 may include a communication component 42, a processor 44, a memory 46, a storage 48, input/output (I/O) ports 50, a display 52, and the like. The communication component 42 may be a wireless or wired communication component that may facilitate communication between the computing system 26, a cloud/remote server 30, a central repository 54 and other communication capable devices.

In some embodiments, the cloud/remote server 30 may host a number of services via computing system resources that may be distributed over multiple locations. In this way, the various computing system resources may be scaled as needed to perform various operations. In some embodiments, the computing system 26 may be implemented via the cloud/remote server 30, as a separate computing system, or both.

Further, datasets acquired via the industrial automation controller 12, the sensors 28, devices in various industrial control systems, and the like may be stored in the central repository 54. The central repository 54 may include one or more databases or data structures for storing and querying datasets in a structured and efficient manner. In addition, the queries, sample graphical object programming code, and the like as described herein may be stored in the central repository 54, such that previously performed analysis operations may be reviewed, modified, and redeployed for different datasets.

The processor 44 may be any type of computer processor or microprocessor capable of executing computer-executable code. The processor 44 may also include multiple processors that may perform the operations described below. The memory 46 and the storage 48 may be any suitable articles of manufacture that can serve as media to store processor-executable code, data, or the like. These articles of manufacture may represent computer-readable media (e.g., any suitable form of memory or storage) that may store the processor-executable code used by the processor 44 to perform the presently disclosed techniques. Generally, the processor 44 may execute software applications that include programs that enable a user to generate graphical object programming code, test the graphical object programming code, and the like. Indeed, the software applications may also evaluate the outputs of the codes using accessible datasets to better ascertain issues or solutions to various discrepancies, anomalies, and the like. That is, the software applications may communicate with the computing system 26 to gather information associated with operations the industrial automation components via the sensors disposed on the industrial automation components and implement control on industrial devices (e.g., via controllers) to adjust operations based on the executed graphical object programming code.

The memory 46 and the storage 48 may also be used to store the data, analysis of the data, the software applications, and the like. The memory 46 and the storage 48 may represent non-transitory computer-readable media (e.g., any suitable form of memory or storage) that may store the processor-executable code used by the processor 44 to perform various techniques described herein. It should be noted that non-transitory merely indicates that the media is tangible and not a signal.

In one embodiment, the memory 46 and/or storage 48 may include a software application that may be executed by the processor 44 and may be used to monitor, control, access, or view one of the industrial automation components. As such, the computing system 26 may communicatively couple to industrial automation components or to a respective computing device of the industrial automation components via a direct connection between the devices, via a router/gateway, or the like.

The I/O ports 50 may be interfaces that may couple to other peripheral components such as input devices (e.g., keyboard, mouse), sensors, input/output (I/O) modules, and the like. I/O modules may enable the computing system 26 to communicate with the industrial automation components or other devices in the industrial automation system via the I/O modules.

The display 52 may depict visualizations associated with software or executable code being processed by the processor 44. In one embodiment, the display 52 may be a touch display capable of receiving inputs from a user of the computing system 26. As such, the display 52 may serve as a user interface to provide parameters and instructions to guide the operation of the computing system 26. The display 52 may be used to display a graphical user interface (GUI) for operating the computing system 26. The display 52 may be any suitable type of display, such as a liquid crystal display (LCD), plasma display, or an organic light emitting diode (OLED) display, for example. Additionally, in one embodiment, the display 52 may be provided in conjunction with a touch-sensitive mechanism (e.g., a touch screen) that may function as part of a control interface for the industrial automation components to control the general operations of the OT environment 10 or the like.

Although the components described above have been discussed with regard to the computing system 26, it should be noted that similar components may make up other computing devices described herein. Further, it should be noted that the listed components are provided as example components and the embodiments described herein are not to be limited to the components described with reference to FIG. 2.

In addition, the computing system 26 may also communicate with a generative artificial intelligence (AI) backplane system 56 and a generative AI system 58. The generative AI backplane system 56 and the generative AI system 58 may operate independently, be hosted by the cloud/remote server 30, and the like. In any case, the generative AI backplane system 56 may interface or interact with the generative AI system 58 to retrieve generative AI responses and feedback related to user inputs (e.g., inquiries) regarding the graphical object programming designs generated based on user inputs.

By way of example, the generative AI system 58 may include any suitable generative AI technology, such as generative pre-trained transformer (GPT) 3, 4, and the like. As such, the generative AI system 58 may include a deep neural network model that has been trained on text data from various sources (e.g., internet). The generative AI system 58 may perform natural language processing tasks, such that received inquiries may be processed and natural language response may be provided in response to the inquiries. In addition, the generative AI system 58 may provide graphical object programming code based on natural language instructions. By way of example, the generative AI system 58 may employ a transformer architecture (e.g., neural network architecture) that uses an encoder to process an input sequence of tokens that may be processed in parallel (e.g., simultaneously) to provide a continuous vector representation of relationships between tokens (e.g., words in inquiries). The generative AI system 58 may also include a decoder that may generate an output sequence of tokens based on the encoded input. The decoder may take context from the encoder and generate output tokens using a model (e.g., autoregressive model).

With this in mind, the generative AI system 58 may be pre-trained on a wide variety of publicly available data, but it may lack the ability to provide contextual answers for propriety datasets, such as the data acquired by the industrial automation components, the controller 12, and the like. That is, these data sources are secured via firewall, encryption, and other security measures to ensure that proprietary datasets and processes are not shared with competitors or the general public. In this way, the generative AI system 58 may not be capable of providing accurate responses to inquiries that are related to proprietary datasets that it may not be able to or may be prohibited from accessing.

In some embodiments, the generative AI backplane system 56 may enable the generative AI system 58 to interface or access proprietary datasets to provide generative responses that are contextualized with respect to the respective industrial system. Indeed, the computing system 26 may facilitate the communication between the generative AI backplane system 56, the generative AI system 58, the various industrial data sources, and the user to provide a generative AI tool that the user may use to obtain real-time feedback responses.

In some embodiments, the generative AI system 58 may be pre-trained on the datasets related to various types of graphical object programming code and corresponding control operations to be performed within a respective industrial system. As such, the generative AI backplane system 56 may process images of certain graphical object programming code the industrial datasets related to design requests received via text, images, audible instructions, and the like. As such, the computing system 26 may efficiently process the received data and apply its language model with respect to the previously created graphical object programming code, previously provided context or information, and the like to provide relevant responses to the inquiries.

In some embodiments, the generative AI system 58 may be trained on data provided in one or more large language models (LLM) 60. In some embodiments, the LLMs 60 may include models that may trained on datasets related to graphical object programming for various devices, to perform various operations within an industrial system, and the like. As such, the LLMs 60 may be trained based on video data and/or audio data related to instructions regarding generating and modifying graphical object programming code for implementing certain operations via devices in the industrial system. In addition, the LLMs 60 may employ data sources available via the Internet or other network-accessible sources to train its models. In this way, the LLMs 60 may allow the generative AI system 58 to generate code, provide contextual explanations with regard to code, and the like for users to better adapt the industrial system for operations.

In some embodiments, at least some of the LLMs 60 may be trained based on image data (e.g., pictures) that represent graphical object programming code that may have been generated using other software tools, implemented in the past, drawn by a user by hand or some software tool, and the like. In this way, the LLMs 60 may be able to contextualize image data related to graphical object programming code based on user provided context and the like. That is, the graphical object programming code provided to the LLMs 60 may be accompanied by user inputs defining the purpose or function of the code. In the same way, the graphical object programming code may be correlated with data provided from industrial devices to determine how the graphical object programming code affects the operations of devices, the industrial system, and the like.

With the foregoing in mind, the computing system 26 may provide a generative Al assistant component (e.g., AI assistant component) that may engage with a user to provide graphical object programming code, update a respective code, provide information related to the respective code, and the like based on the information within the LLMs 60. Indeed, in some embodiments, the computing system 26 may receive audio input (e.g., voice data) that may enable customers to query code projects related to industrial automation design proposals, gather project insights related to the designs, and generate conversation or natural language responses that provide insight into the queries without documentation (e.g., hands-free and on-the-go).

The LLMs 60, in some embodiments, may be trained based on packages or formatted datasets associated with industrial devices in the industrial system that may be acquired via the sensors 28, the industrial automation controller 12, or the like to assist in providing appropriate context to the inquiries provided to the computing system 26. The LLMs 60 may assist in deriving actional insights (e.g., commands or instructions for industrial components) from the provided datasets to aid in providing updated programming code and the like.

To train the LLMs 60, the LLMs 60 may receive pre-defined prompts via data files, user input, or the like from a variety of sources, such that each LLM may perform a particular operation in conjunction with other LLMs. For example, an LLM trained based on speech and text may use prompts that may include a prompt template structure for expected inquiries that may be tailored for generating graphical object programming code, modifying the programming code in view of detected anomalies or datasets, and the like. The prompts may provide context to inquiries relative to datasets with respect to the generated graphical object programming code, such as predicted outcomes associated with implementing the code and the like.

Although the embodiments described herein are discussed with reference to LLMs, it should be noted that the techniques described herein may be implemented using foundation models instead. A foundation model may include a broader, large-scale AI model pre-trained on diverse datasets that can be adapted to various downstream tasks, as compared to the LLMs. Indeed, the LLM may be a type of foundation model. As such, the foundation models may serve as a general AI base that can be adapted for many applications, with LLMs being a specialized form of that base designed for language-related functions.

With this in mind, the foundation models may be trained on massive, diverse datasets that may include text, images, video, speech, and the like. In this way, the computing system 26 may use the foundational models to serve as a versatile base that may be used to generate the graphical object programming code based on text inputs, speech inputs, image inputs, and the like. In this way, the foundation models may be used with the embodiments presented herein to efficiently generate the graphical object programming code. In addition, the foundation models may include other categories of models such transformers, mamba, vision language models (VLMs), small language models (SMLs), and the like.

In some embodiments, the computing system 26 may receive data from other control systems via a distributed control system 62. The distributed control system 62 may include computing devices with communication abilities, processing abilities, and the like. For example, the distributed control system 62 may include processing controllers, a control system, a programmable logic controller (PLC), a programmable automation controller (PAC), or any other controller that may monitor, control, and operate an industrial automation device or component. The distributed control system 62 may be incorporated into any physical device (e.g., the industrial automation components) or may be implemented as a stand-alone computing device (e.g., general purpose computer), such as a desktop computer, a laptop computer, a tablet computer, a mobile device computing device, or the like. For example, the distributed control system 62 may include many processing devices logically arranged in a hierarchy to implement control operations by disseminating control signals, monitoring operations of the industrial automation system, logging data as part of historical tracking operations, and so on.

In an example distributed control system 62, different hierarchical levels of devices may correspond to different operations. A first level may include input/output communication modules (IO modules) to interface with industrial automation components in the unit. A second level may include control systems that control components of the first level and/or enable intercommunication between components of the first level, even if not communicatively coupled in the first level. A third level may include network components, such as network switches, that support availability of a mode of electronic communication between industrial automation components. A fourth level may include server components, such as application servers, data servers, human-machine interface servers, or the like. The server components may store data as part of these servers that enable industrial automation operations to be monitored and adjusted over time. A fifth level may include computing devices, such as virtual computing devices operated from a server to enable human-machine interaction via an HMI presented via a computing device. It should be understood that levels of the hierarchy are not exhaustive and nonexclusive, and thus devices described in any of the levels may be included in any of the other levels.

One or more of the levels or components of the distributed control system 62 may use and/or include one or more processing components, including microprocessors (e.g., field programmable gate arrays, digital signal processors, application specific instruction set processors, programmable logic devices, programmable logic controllers), tangible, non-transitory, machine-readable media (e.g., memory such as non-volatile memory, random access memory (RAM), read-only memory (ROM), and so forth. The machine-readable media may collectively store one or more sets of instructions (e.g., algorithms) in computer-readable code form, and may be grouped into applications depending on the type of control performed by the distributed control system 62. In this way, the distributed control system 62 may be application-specific, or general purpose. In any case, data collected from the distributed control system 62, stored in the central repository 54 or the like may be made available to the computing system 26 in accordance with embodiments described herein.

### Multi-Modal Assistant for Graphical Object Programming

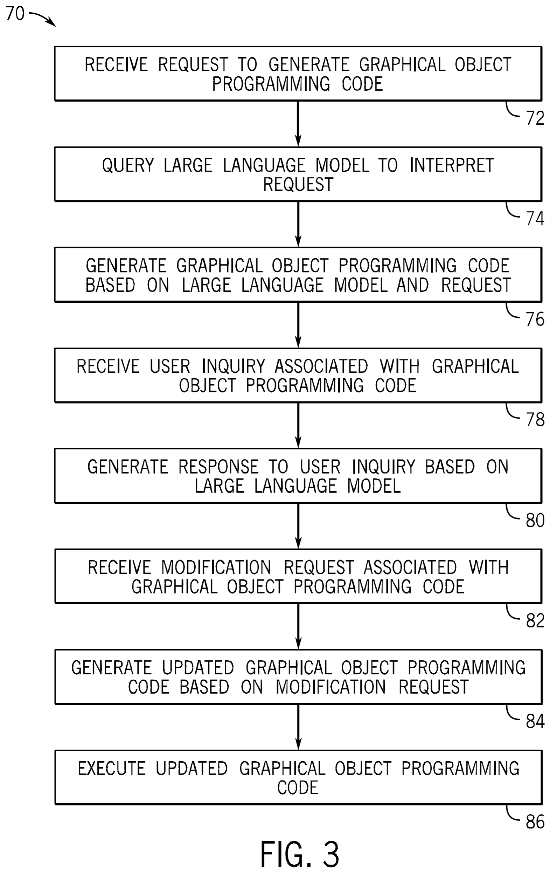

With this in mind, FIG. 3 illustrates a flow chart of a method 70 for providing graphical object programming code using large language models, in accordance with embodiments presented herein. Although the following description of the method 70 will be discussed as being performed by the computing system 26, it should be understood that any suitable system may perform the method 70 in any suitable order and by any suitable computing device.

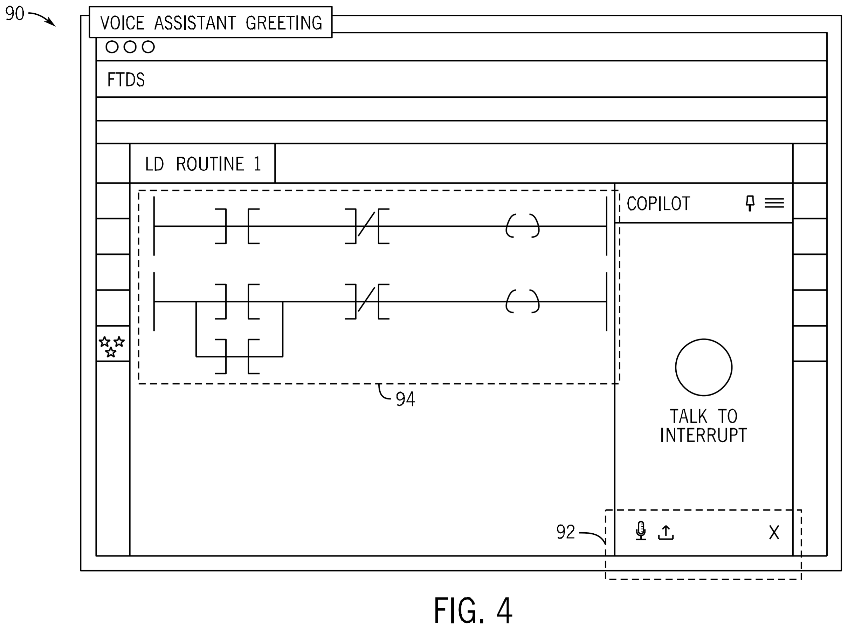

Referring now to FIG. 3, at block 72, the computing system 26 may receive a request to generate graphical object programming code. In some embodiments, the requests may be received in a number of different formats. For example, referring to FIG. 4, the computing system 26 may present an API visualization 90 that may enable the user to provide the request in a number of different modes. For instance, the API visualization 90 may include an input parameter 92 in which a user may select an audio input (e.g., voice), a data input, a text input, and the like. In this way, the computing system 26 may receive the requests in multiple modes or formats from the user.

Indeed, the audio input may include voice instructions provided by a user. In addition, the audio input may correspond to a sound profile of a machine or industrial device that the user may use to request that the computing system 26 interpret and generate graphical programming code to emulate or recreate the same sound profile in connected devices. The data input may include an upload function that may enable the computing system 26 to receive data files such as images, text-documents, project files from programming design software, and the like. In addition, the text input may be received via a chat visualization or other interface that may receive text-based based inputs from the user.

In some embodiments, the data input may correspond to a particular document (e.g., design spec, IO map, P&ID diagram, etc.), and the computing system 26 may receive an upload of the document. In turn, the computing system 26 may use the LLM 60 to interpret the document, provide a summary of the document in a conversational format, determine any related vectors within the document (e.g., corresponding to LLMs), and the like, such that the computing system 26 may provide information related to the document, update the graphical object programming code, and the like. In addition, after the document is uploaded and analyzed with respect to the LLM 60, the computing system 26 may receive inquiries and questions from the regarding the uploaded document, such that the computing system 26 may provide explanations and context for users hoping to flesh out their system (early design) or those seeking to troubleshoot their system.

The request received at block 72 may provide information related to a desired operation to be performed by a device or system via graphical object programming code (e.g., ladder logic), a type of device or system in which to perform the desired operation, and the like. By way of example, the graphical object programming code may include ladder logic that may involve using two vertical power rails and horizontal "rungs" with symbols for inputs (contacts) and outputs (coils) to create control logic that may be implemented on programmable logic controllers (PLCs).

The LLMs 60, as discussed above, may include models trained on the programming of these types of graphical objects with respect to various desired operations, control of certain devices, and the like. As such, the computing system 26 may receive the request in order to generate graphical programming code to perform a desired operation. With this in mind, at block 74, the computing system 26 may query the LLMs 60 to identify a suitable LLM that may be used to interpret the request received at block 72. The computing system 26 may then cross reference the intent derived from the request to potential outputs that may be defined by LLMs related to designing graphical object programming code. That is, the computing system 26 may leverage the models provided in the LLM 60 to determine a purpose or objective associated with the request, identify relevant products or devices associated with the request, retrieve graphical programming code that may include components or may be related to the request, and generate proposed graphical object programming code that may be employed by the industrial system or respective devices. Indeed, the computing system 26 may leverage the models provided in the LLM 60 to determine aspects or features of the request, such that the computing system 26 may generate corresponding graphical object programming code.

At block 76, the computing system 26 may generate the graphical object programming code based on the results of the query, the models of the LLM 60, and the request. The graphical object programming code may be generated based on an artificial intelligence component that uses the models in the LLM 60 to interpret the request, identify the relevant models within the LLM 60, and generate an appropriate response (e.g., graphical object programming code) based on the patterns and vectors defined in each of the models of the LLM 60. As such, the computing system 26 may present graphical programming code 94 within the API visualization 90.

As shown in FIG. 4, the graphical programming code 94 may include ladder logic generated based on the request provided at block 72. In some embodiments, the graphical programming code 94 may be generated based on user inputs (e.g., via design software) and the request received at block 72 may be related to adjusting or modifying the presented graphical programming code 94. Additional details with regard to modifying presented graphical programming code will be discussed below with reference to block 82.

At block 78, the computing system 26 may receive a user inquiry associated with the presented graphical programming code. As such, the user inquiry may be provided via the multiple modes described above, such as audio, data, text, and the like. The user inquiry may be related to aspects of the presented graphical object programming code including elements thereof. That is, the user inquiry may request information related to specific elements of the presented graphical object programming code to allow the user to better understand the function of each element. In addition, the user inquiry may be related to operations expected to occur in view of the presented graphical object programming code. In some embodiments, the user inquiry may include requests for information related to controlling aspects of a respective device, process, or system defined by the presented graphical object programming code.

At block 80, the data received from the industrial devices or related to the operation of industrial devices may be used to generate an appropriate response. The response may be generated by evaluating the user inquiry with respect to the content of the LLM 60 and the context of the presented graphical object programming code. In some embodiments, the response to the user inquiry may be provided via audio output, visual output, textual output, and the like. As such, the audio output may include a synthesized voice that provides a contextual response to the user inquiry. In the same manner, the visual and textual output may provide visual indicators and text responses that address the user inquiry.

At block 82, the computing system 26 may receive a modification request regarding the presented graphical object programming code. The modification request may be provided via any of the multiple modes described above and may specify modifications to the function of the presented code, the effects to the devices associated with the presented code, the effects to the operations of the industrial system, and the like. The modification request may be received in any of the modes described above in a natural language format, a visual format, or the like.

Based on the modification request, the computing system 26 may, at block 84, generate updated graphical object programming code to accommodate or address the modification request. As such, the computing system 26 may leverage the LLM 60 to determine the intent of the modification request and generate updates or changes to update the presented graphical object programming code. The computing system 26 may present the updated graphical object programming code to highlight or visually distinguish the updates made to the generated graphical object programming code. In this way, the computing system 26 may provide an indication to the user regarding the updates.

After the computing system 26 presents the updated graphical object programming code, the user may be presented with the option to either accept or discard the update or change. In some embodiments, by accepting the changes, the computing system 26 may incorporate the changes into the programming portion for execution. On the other hand, discarding the updates or changes may cause the computing system 26 to remove the changes and allow the user to provide additional inputs to the programming portion.

At block 86, the computing system 26 may execute the updated graphical object programming code. In some embodiments, to execute the updated graphical object programming code, the computing system 26 may query the industrial devices that may be communicatively coupled to the computing system 26 and retrieve information related to the identity of the product, the type of product, the network address of the product, and the like. In some embodiments, the information may be stored in a database or other storage component. In addition, the computing system 26 may retrieve the information from a gateway device, the device itself, and the like by directly accessing the respective device and retrieving the respective information. Further, the computing system 26 may leverage the LLMs 60 to identify the suitable devices associated with the updated graphical object programming code based on the request, the intended function of the updated graphical object programming code, and the like.

After identifying or receiving information (e.g., from a user) regarding a destination device, the updated graphical object programming code may be uploaded or sent to the industrial controller 12 or other suitable control system. In turn, the respective device may validate the updated graphical object programming code, request approval from a user to implement the updated code or update the respective operations to cause the respective operations of to adjust appropriately. In some embodiments, the computing system 26 may compile the updated graphical object programming code into a machine code or other suitable format that may be executable by the respective device and send the resulting code to the respective device for execution. Indeed, the LLMs 60 may include models that the computing system 26 may use to convert or translate the updated graphical object programming code into the appropriate format.

By way of operation, the computing system 26 may continuously sample the audio surroundings to detect an activation word or phrase to initiate the method 70. In addition, as discussed above, the computing system 26 may be triggered from a chat panel visualization as depicted in FIG. 4. In some embodiments, the computing system may provide visual, textual, and auditory responses that to the user's requests. Indeed, the computing system 26 may provide a transcription of the detected audio request, such that the user may modify or adjust the request based on the transcribed request.

In some embodiments, as the computing system 26 provides a response (e.g., audible, visual, text), the user can speak to interrupt the response and stop the computing system 26 from presenting the response. This way, if the user recognizes that the response is not relevant to their request or desired result, the user may forego or stop the current output by the computing system 26 and provide an additional request. As discussed above, the computing system 26 may generate a transcript of the inputs and outputs received by and provided by the computing system 26 for reference. That is, the audibly received input, the generated output, or both may be reproduced in text format within a chat window. In turn, the user may enter text-based requests into the chat window to continue the conversation with the computing system 26 that may have been previously conducted in an audible (e.g., voice) format.

### Inline Input Visualization

Keeping the foregoing in mind, in some embodiments, the computing system 26 may provide certain tools to allow users to interact with artificial intelligence (AI) components that may assist the user in generating the graphical object programming code. By way of example, the computing system 26 may provide a visualization that includes a programming portion to allow a user to input graphical objects for programming a device. In addition to the programming portion, the computing system 26 may provide for an inline input visualization in which users may interact with the artificial intelligence (AI) component described herein. The AI component (e.g., implemented by the computing system 26) may provide the recommended modifications or changes as described above in a location relative to the respective graphical object programming code. For instance, in a ladder logic program, the computing system 26 may present an inline input visualization adjacent to the ladder logic program depicted in the programming portion of the displayed visualization to allow the user to engage with the AI component with respect to the ladder logic program. In turn, the computing system 26 may employ AI algorithms, the LLMs 60, or the like to determine a proposal for a ladder "rung" to implement a requested function. As such, the computing system 26 may interact with an AI component that may determine the graphical programming objects that correlate to the input requests from the user and expected control operations for implementation as described above.

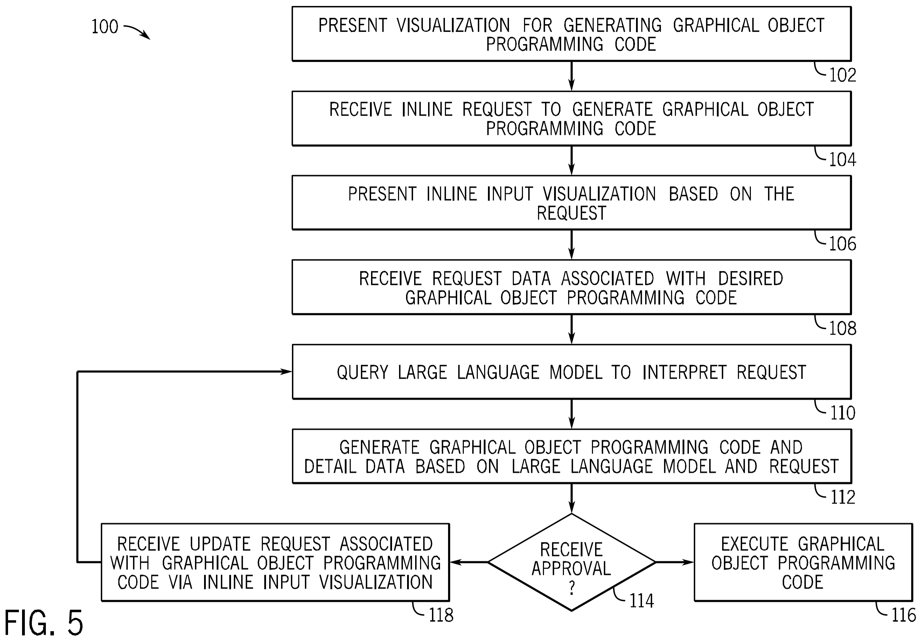

FIG. 5 illustrates a flowchart of a method 100 for providing inline input visualizations in a graphical object programming environment, in accordance with embodiments described herein. Although the following description of the method 100 is described as being performed by the computing system 26 an in a particular order, it should be understood that the method 100 may be performed by any suitable computing system in any suitable order.

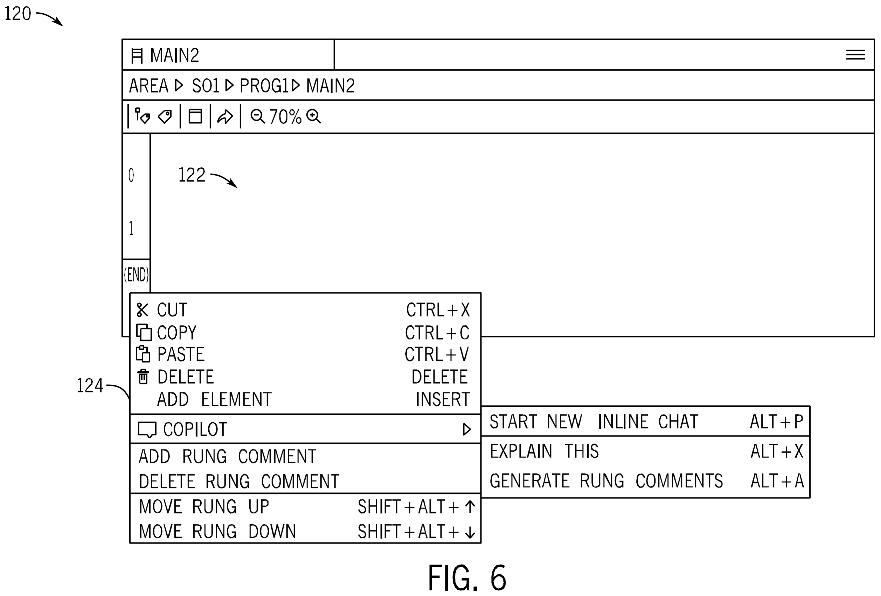

Referring now to FIG. 5, at block 102, the computing system 26 may present a visualization (e.g., API visualization 90) for generating graphical object programming code. As such, the computing system 26 may present a design environment for creating programming code for industrial controllers, control systems, and the like. In some embodiments, the computing system 26 may present the visualization using a software application or the like. By way of example, FIG. 6 illustrates an example visualization 120 that may include a programming portion 122 that may be composed of a number of lines that correspond to rungs of code.

At block 104, the computing system 26 may receive an inline request to generate the graphical object programming code. The inline request may be provided via a user input device (e.g., mouse, touch, pointer) that provides an indication that an inline input visualization may be requested at a particular location (e.g., line, rung) within the programming portion of the visualization. As shown in FIG. 6, an inline request 124 may be received at a position that corresponds to a particular line presented in the programming portion 122. The inline request 124 may include options related to initiating an inline chat or inline input visualization for engaging with the AI component of the computing system 26.

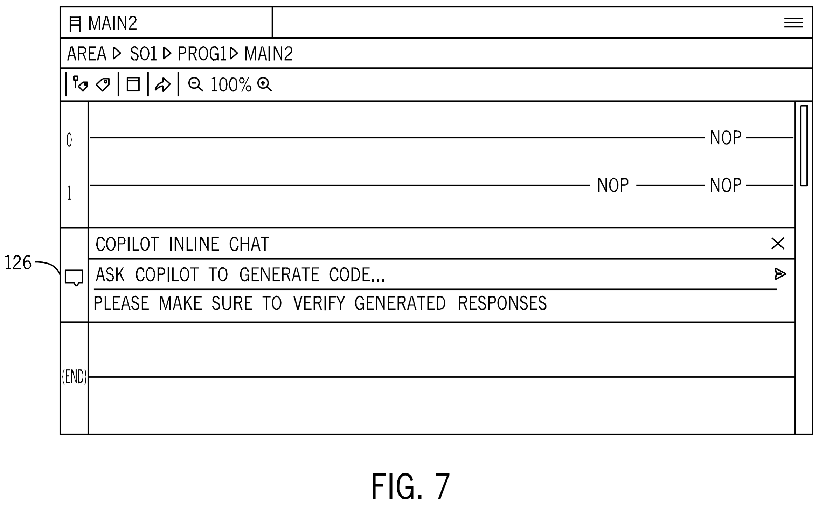

After receiving the inline request, the computing system 26 may present an inline input visualization at the position that corresponds to a location of the inline request at block 106. By way of example, the computing system 26 may generate an inline input visualization 126 at the location that corresponds to the inline request 124, as shown in FIG. 7. The inline input visualization 126 may include an input field that may allow the user to provide input (e.g., voice, text, data) as described above with reference to FIG. 3. As such, the inline input visualization 126 may receive a request to generate graphical object programming code as described above with reference to block 72. The inline input visualization 126 is presented in place of the graphical object programming code. As such, instead of the user designing the graphical object programming code, the present embodiments enable the user to generate the graphical object programming code based on input requests in text, audio, data, and the like. In some embodiments, the input requests received by the user may be provided in natural language, such that the AI component of the computing system 26 may transform the input language into requested graphical code operators or objects. After generating the proposed graphical programming code, the AI component may present the graphical programming code in the programming portion. In addition, the AI component may provide the user with the ability to provide additional requests to add/modify the generated graphical code objects (e.g., ladder elements) as described above.

By providing the inline input visualization 126, the computing system 26 may improve the user's experience when designing or creating graphical object programming code because the inline input visualization 126 corresponds to a line in which the rung of code may be generated. Indeed, as shown in FIG. 7, the inline input visualization 126 is depicted in a line of code to maintain other lines or rungs of code that may be presented above or below the respective line. In this way, the user may view the other lines of code while engaging with the AI component. Further, the computing system 26 may present the inline input visualization 126 within a proximity or adjacent to a respective rung or line of graphical object programming code to enable the user to engage the Al component with respect to the content of the respective line of graphical object programming code.

In some embodiments, the inline input visualization 126 may include a textbox input field that may provide the user the ability to enter a prompt for the AI component (e.g., via its AI Backend component) to process. In addition to the text input field, the inline input visualization 126 may provide audible or data inputs as describe above. It should be noted that since the graphical programming code generated for the request is made up of graphical programming objects, the AI component-generated graphical programming code, which is unique from text due to the logical functions represented by each graphical programming object.

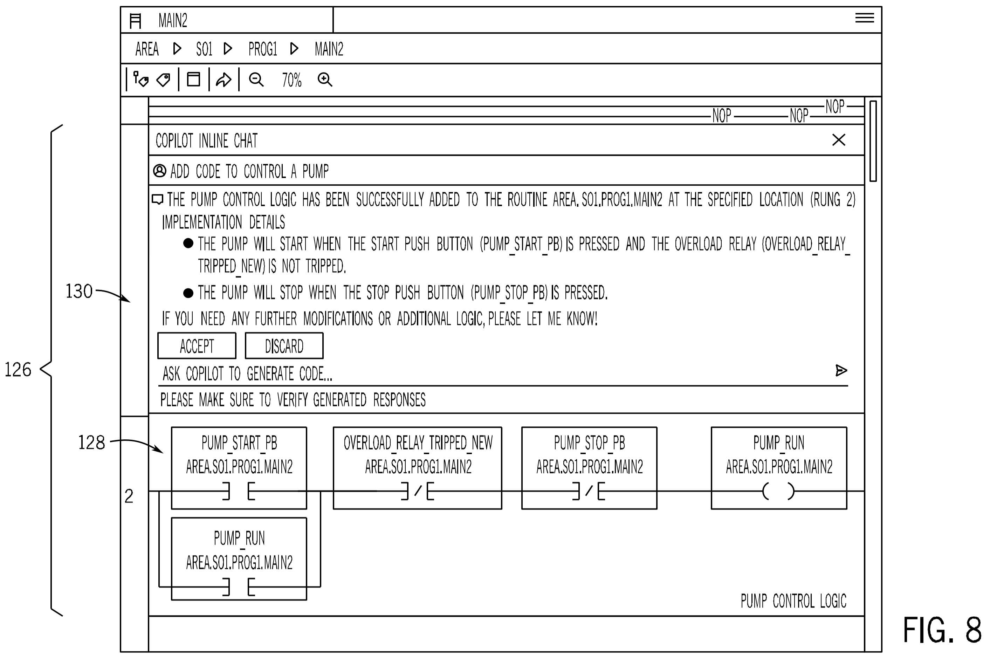

At block 108, the computing system 26 may receive request data that may be associated with a desired graphical object programming code. In some embodiments, the request data may correspond to the request described above with respect to block 72. In the same manner, blocks 110 and 112 may correspond to blocks 74 and 76, respectively. FIG. 8 illustrates an example graphical object programming code generated within a programming visualization 128 in response to receiving the request data. At block 112, in addition to generating the graphical object programming code, the computing system 26 may provide detail data related to the generated code within a description visualization 130. The detail data may provide information related to the generated graphical object programming code in a natural language format, such that users may understand the context of the generated graphical object programming code. The detail data may be generated using LLMs 60 as described above.

At block 114, the computing system 26 may determine whether the generated graphical object programming code is acceptable to the user based on an input received via the inline input visualization 126. In response to receiving the indication that the code is acceptable, the computing system 26 may proceed to block 116 and execute the graphical object programming code as described above. If the computing system 26 determines that the generated graphical object programming code is not acceptable or has not been approved by the user, the computing system 26 may proceed to block 118 and receive an update request via the inline input visualization to modify the graphical object programming code. As such, the computing system 26 may return to block 110 to interpret the update request and update the graphical object programming code accordingly. Indeed, in some embodiments, the computing system 26 may proceed to block 80 of the method 70 after receiving the update request at block 118.

With the foregoing in mind, in some embodiments, the AI component of the computing system 26 may interact with an AI backend component to present graphical object programming code instead of manually adding/creating ladder elements (e.g., instructions, branches, and rungs). That is, the computing system 26 may allow the user to open an AI component-generated rung instead of requesting one or more rungs to be generated anew. As such, the user may also select one or more rungs (or one or more ladder elements before opening) that may already be prepared and presented in the programming visualization 128. In this case, the actions by the AI component may be related to those respective graphical programming objects (e.g., selected ladder logic elements) presented in the programming visualization 128. It should be noted that the graphical programming objects may be replaced if user requests are interpreted by the AI component to add elements. In some embodiments, the user may provide an input that corresponds to specific questions regarding the presented graphical programming objects, the AI component may then provide natural language text that responds to the input. In some embodiments, the AI component may provide an indication of a history of previous requests and responses. Indeed, the previously provided requests and generated responses may be saved, such that future requests in the same AI-generated rung may use information and data from previous requests for more efficient processing.

### Testing Generated Graphical Object Programming Code

In some embodiments, after the graphical object programming code is generated and presented via the API visualization 90, the programming visualization 128, and the like, the computing system 26 may include a validation operation that may include simulating the operation of a device that may execute the generated graphical object programming code. As the computing system 26 may pass the generated graphical programming object code to a simulation component to simulate the operations of a simulated device with simulated inputs and corresponding outputs. After determining that the simulated outputs match the expected outputs for the respective rung, the computing system 26 may validate the generated graphical object programming code for execution.

To perform additional validation operations, the computing system 26 may also test and generate recommendations to modify the graphical object programming code (e.g., PLC code), user-generated graphical programming code, and the like based on the results of the tests. Indeed, in some embodiments, the computing system 26 may receive a request to examine graphical object programming code (e.g., PLC code) and create a test script or plan that covers various possible test cases for verifying that the graphical object programming code is valid. In some embodiments, the computing system 26 may generate a test script or a plan, present it to the user via the API visualization (e.g., chatline visualization), receive requests to adjust the script or plan, and execute the updated script. The test script or plan may include test code (e.g., PLC code) that may be generated for the purpose of testing the graphical object programming code (e.g., application code). After generating the test script or plan, the computing system 26 may receive an input indicative of an affirmation to execute the test script or plan. In some embodiments, a simulation component of the computing system 26 may execute the test code or plan using a controller emulation system that may execute the test code.

After the controller emulation system executes the test code, test results of the respective test code may be presented via the API visualization 90 to enable the user to review the test results. The test results may indicate whether each test code passed and failed based on whether the expected results were obtained or not. In some cases, the test results may provide performance information that may include a comparison with respect to the performance of the code with respect to certain threshold performance levels.

After receiving the test results, the computing system 26 may use the test results to determine actions that may be undertaken. For instance, for any failed test, the computing system 26 may determine an action that may be available for the user to fix or change the graphical object programming code and re-run the test until every test passes. The computing system 26 may determine the actions based on a machine-learning algorithm that is trained on previously implemented actions, which may be represented in the LLMs 60, to modify graphical programming code in response to certain failed tests.

For any performance related test results, the computing system 26 may generate one or more optimization options to modify the graphical programming code to improve the performance of any related test. Again, the computing system 26 may employ a machine-learning algorithm, along with the LLMs 60, to generate the optimization options. It should be noted that the computing system 26 may also provide a natural language explanation to the user regarding each of the optimization options. In this way, the user may evaluate each optimization option and select one based on their preferences. In some embodiments, the optimization options may be presented via the API visualization 90 or any other suitable visualization along with the explanations. The user may then select an option to optimize the code and re-run the test. In some embodiments, the computing system 26 may automatically select an optimization option and re-run the test until the test results achieve certain thresholds.

In some embodiments, the computing system 26 may be used to emulate operations of a respective device (e.g., PLC, Logix execution) based on the generated graphical object programing code to compile a domain-specific language (DSL) code (e.g., graphical programming code) and create a text-friendly code, such as Python, therefrom. In this way, the computing system 26 may execute the generated code (e.g., text-friendly code) in a sandbox environment to validate the execution and/or correctness of the code using a larger library or models, LLMs 60, or the like, which may be trained based on text-based programming code.

By way of example, the computing system 26 may create emulated code version in text-based format of a graphical object programming code to enable agent execution via function calls to do a deeper validation of each instruction. By converting the graphical programming code into the text-based code, the computing system 26 may enable a user to better test or validate the code in the sandbox environment using another programming language that may be more familiar to them. Moreover, the text-based code may also enable the computing system 26 to use certain LLMs to parse, interpret, and provide recommendations (e.g., corrections) to the LLM-friendly code. In some embodiments, the computing system 26 may create a DSL-compiled version in a suitable format specified by the user, thereby enabling emulation of portions of the code before the full controller emulation, which may involve additional infrastructure and API support to enable this capability.

With the foregoing in mind, FIG.5 illustrates a flowchart of a method 150 for generating test scripts to verify the operability of graphical object programming code generated using LLMs, artificial intelligence components, and the like. Although the following description of the method 150 will be described as being performed by the computing system 26 and in a particular order, it should be understood that the method 150 may be performed by any suitable computing device in any suitable order.

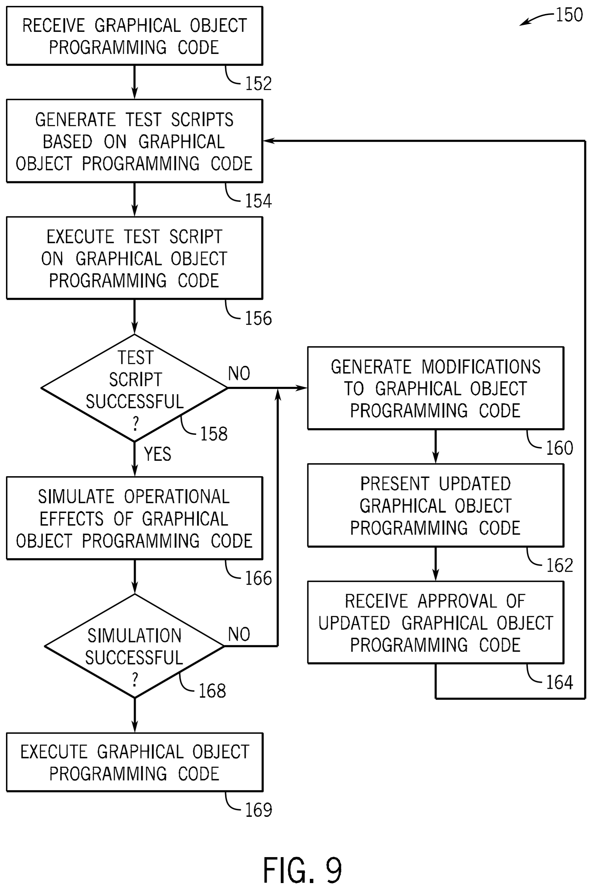

Referring to FIG. 9, at block 152, the computing system 26 may receive graphical object programming code that may be generated based on the techniques described above, generated by user input, or the like. In some embodiments, the computing system 26 may detect the graphical object programming code in the API visualization 90 or other images presented via a display. That is, the computing system 26 may automatically detect the graphical object programming code depicted on the display based on models, sample graphical object programming code, and the like.

After receiving the graphical object programming code, the computing system 26 may proceed to block 154 and generate one or more test scripts for verifying the operability of the graphical object programming code. The test scripts may include instructions (e.g., code) that may check to verify that the graphical object programming code operates as intended or expected. The test code may include a series of steps that cause the graphical object programming code to execute based on certain inputs (e.g., pseudo, random, user defined) and produce certain outputs. The outputs may include visual or audible outputs presented via the computing system 26, as well as outputs that may be expected within the motor 14 or other load devices in an industrial system. As such, the test scripts may cause the graphical object programming code to perform some tasks that may be verified based on data received from the sensors 28 or the like.

In some embodiments, the test script may verify that the graphical object programming code is capable of being compiled and processed by a respective control system. In addition, the test code may confirm whether edge cases or instances in which errors are to be generated are accurately being produced. In addition, the test script may ensure that the graphical object programming code does not interfere with the functionalities of other graphical object programming code being executed by the respective control system.

The test script may be generated based on the LLMs 60, which may include a model related to generating test scripts to test various types of programming code. In some embodiments, the respective LLM may be trained to associate different test scripts with different functionalities of various types of graphical object programming code for different types of industrial devices connected to different types of loads. As such, the training of the LLM may provide the computing system 26 (e.g., AI component executed therein) to leverage the received graphical object programming code with the test scripts that may be used to verify that the functions and operations to be performed by the graphical object programming code are achievable. Indeed, the respective LLM may include relationships between the intended purpose of graphical object programming code and expected outputs, expected errors, expected edge cases, and the like. In this way, the computing system 26 may then leverage a separate LLM associated with generating test scripts to create test scripts for verifying that the intended objectives of the graphical object programming code are achieved through the execution of the code. In addition, the test script may verify that the graphical object programming code is correctly drafted or presented with respect to syntax, expected formats, and the like.

After generating the test scripts, at block 156, the computing system 26 may execute the test script using a test runner tool that may execute the test script and provide an output for each test provided within the test script. The executed test script may perform a variety of tests using inputs that may be defined in the test script and compare the generated outputs of the graphical object programming code with the expected outputs. In some embodiments, each test script may include metadata or related information that provides expected outputs, response, outcomes, or the like for the executed test script.

At block 158, the computing system 26 may determine whether the test script is successful. In some embodiments, the test script is successful if each of the generated outputs match the expected outputs for the various tests of the test script. If the generated outputs match the expected outputs, the computing system 26 may determine that the test script was executed successfully. In some embodiments, the test script may be determined to be executed successfully in response to a percentage or number of the tests performed by the test script (e.g., matching outputs with expected outputs) exceed a threshold amount or number. Indeed, the threshold amount may be 100% to ensure that the graphical object programming code performs as designed but may also include lower percentages. In response to the test script being unsuccessful, the computing system 26 may proceed to block 160 in response to the test script not being successful.

At block 160, the computing system 26 may generate modifications to the graphical object programming code. In some embodiments, a separate LLM may be trained based on updates or modifications made to graphical object programming code and various invalid test results associated therewith. As such, the computing system 26 may determine suitable modifications or changes to the graphical object programming code based on the respective test that may have been unsuccessful. The generated modifications may provide proposals to change the graphical object programming code that may result in an updated graphical object programming code. At block 162, the computing system 26 may present the updated graphical object programming code via the user interface, such as the API visualization 90 or the like. The updated graphical object programming code may highlight or distinguish the updates or changes generated by the computing system 26, such that a user may view the suggested modifications. In some embodiments, the proposed changes may be provided in a different color, font, image, or visual effect over a presentation or visualization of the previous graphical object programming code. In addition, a side-by-side visualization may be provided for the user to compare the two codes. In any case, it should be noted that the changes or modifications may be presented to the user in a variety of formats and should not be limited to those described herein.

At block 164, the computing system 26 may receive an approval of the modifications related to the graphical object programming code originally received at block 152. In some embodiments, the approval may include one or more of the proposed modifications. However, it should be noted that the computing system 26 may also forgo receiving approval for the modifications and automatically incorporate the modifications to generate the updated graphical object programming code. In either case, the computing system 26 may then return to block 154 and generate new test scripts for the updated graphical object programming code and perform the remaining portion of the method 150 to verify that the updated graphical object programming code is operable.

Referring back to block 158, in response to the test script being successful, the computing system 26 may proceed to block 166 and simulate the operational effects of executing the graphical object programming code to devices in the industrial system, the industrial system itself, and the like. At block 166, the computing system 26 may emulate or simulate the effects of executing the graphical object programming code in an emulation environment, a digital twin environment, and the like. That is, the computing system 26 may have access to an emulator system that digitally represents the industrial system and the corresponding industrial devices that may be affected by the execution of the graphical object programming code. As such, the computing system 26 may send data represented of the graphical object programming code (e.g., the code itself), the expected outputs of the graphical object programming code (e.g., based on test scripts), intended effects on the devices and/or the industrial system of the graphical object programming code (e.g., determined based on LLM analysis), and the like to an emulator system.

The emulator system may include digital representations of a corresponding the OT environment 10, industrial automation system, and the like. The emulator system may then execute the graphical object programming code, such that it adjusts the simulated operations of a respective device and respective system. In this way, the computing system 26 may test the effects of the graphical object programming code with respect to the expected effects to the operational parameters (e.g., speed, power, production, temperature, pressure) of the respective device or system prior to implementing the code.

At block 168, the computing system 26 may determine whether the simulation results were successful. That is, the computing system 26 may analyze the simulated outputs of the respective device, the respective system, and the like and compare them to the expected outputs. In some embodiments, the expected outputs may correspond to a range of values specified for the device or system. These values may be obtained by querying an appropriate LLM associated with the expected operational parameters of the respective device, the respective system, and the like. The computing system 26 may consider the simulation to be successful in response to the simulated outputs being within threshold ranges (e.g., percentages, values) of respective expected outputs. In addition, the simulation may be considered to be successful in response to the simulated outputs failing to cause errors, alarms, or faults in other devices, sensor data, or other datasets related to the operations of the industrial system.

In response to determining that the simulation is successful, the computing system 26 may proceed to block 169 and execute the graphical object programming code as described above with reference to FIG. 3. If, however, the simulation is not successful, the computing system 26 may proceed to block 160 and determine modifications to the graphical object programming code to address the simulation results. As such, an appropriate LLM may be trained to map modifications of graphical object programming code to simulation results, errors, and the like.

In some embodiments, if the test scripts and/or the simulation are successful, the computing system 26 may still generate modifications or changes to the graphical object programming code to provide more optimized or improved results. That is, the computing system 26 may employ LLMs trained on efficient programming methodologies to identify techniques or changes to the graphical object programming code that may result in improved test script results, simulation results, or both. After identifying the optimization options or changes, the computing system 26 may present the suggested modifications for the user to accept and implement. Alternatively, the computing system 26 may automatically update the operation of the respective device based on the determined optimized graphical object programming code. The computing system 26 may then provide a summary of the improved measurements, datasets, or other measurable parameters to the user for review.

In some embodiments, the test scripts and the simulation may be implemented in sandbox or developmental programming environments in which the effects of the graphical object programming code and the test scripts may be isolated from affecting other systems. To implement the test scripts and simulations, the computing system 26 may convert or translate the graphical object programming code into a text-based code of another suitable programming language, such as Python. As such, the computing system 26 may leverage one or more LLMs that may be trained to convert graphical object programming code into text-based programming languages. In some embodiments, the computing system 26 may select an appropriate language to convert the graphical object programming code based on the amount of training datasets that have been used to train a corresponding LLM. In this way, the computing system 26 may employ an LLM related to a particular code that may have been trained more thoroughly to identify more possible solutions.

Indeed, as results from the text-based programming LLMs are used by the computing system 26 to update graphical object programming code, the computing system 26 may update a respective LLM associated with the graphical object programming code to include the identified solutions. In this way, the LLM associated with the graphical object programming code may be continuously updated and used in the future to more efficiently provide responses in view of the newly trained data. As a result, the computing system 26 may rely on the LLMs associated with the graphical object programming code to determine solutions without converting the graphical object programming code into text-based code, thereby improving the computational efficiency (e.g., speed, power, processing) of the computing system 26.

### Realtime Generative AI for Updating Graphical Object Programming Code

Keeping the foregoing in mind, in some embodiments, the AI component of the computing system 26 may provide real-time generative AI functions based on datasets available to the computing system via networks and the like. That is, the AI component, for example, may employ streaming capabilities to identify logical patterns in datasets and generate insights, alerts, and predictions in real-time.

The collected datasets may include data acquired from the industrial automation controller 12, other control systems, the sensors 28, other industrial devices, and the like. The datasets may include historical data, static data (e.g., offline tags), and the like. In addition, the datasets may include audio, video, live data (e.g., from control system), and the like. Using an LLM Realtime API support system, the AI component may mix or cross analyze the various types of data within the datasets to identify patterns with the data.

In some embodiments, the AI component may leverage the LLMs 60 to recognize the semantic understanding of the collected data to enable it to combine datasets from various sources to generate insights, alerts, and predictions in real-time. By way of example, audio and video data may be collected along with datasets from a control system to generate insights with regard to the operation of the industrial device or industrial system and provide recommendations for improving operations using the LLMs 60. In one embodiment, a mobile phone device may collect audio and video data surrounding an industrial device. In another embodiment, a dedicated industrial device with this capability may collect the audio and video data. In any case, the AI component may stream and receive the collected data to augment programming design and operational tools (e.g., FactoryTalk Design Studio) to improve operations of the respective system. The AI component, which may be linked with logic and live data output by other industrial devices, may provide a unique semantic meaning and understanding about the logical analysis related to the collected datasets and the physical aspect of the application, such as an arrangement of equipment, sections, actuators, motors, valves, instrumentation, sensors, and the like. In this way, the AI component may then generate updated graphical object programming code or code itself to adjust operations of respective devices to account for the collected data, the determined insights, and the like.

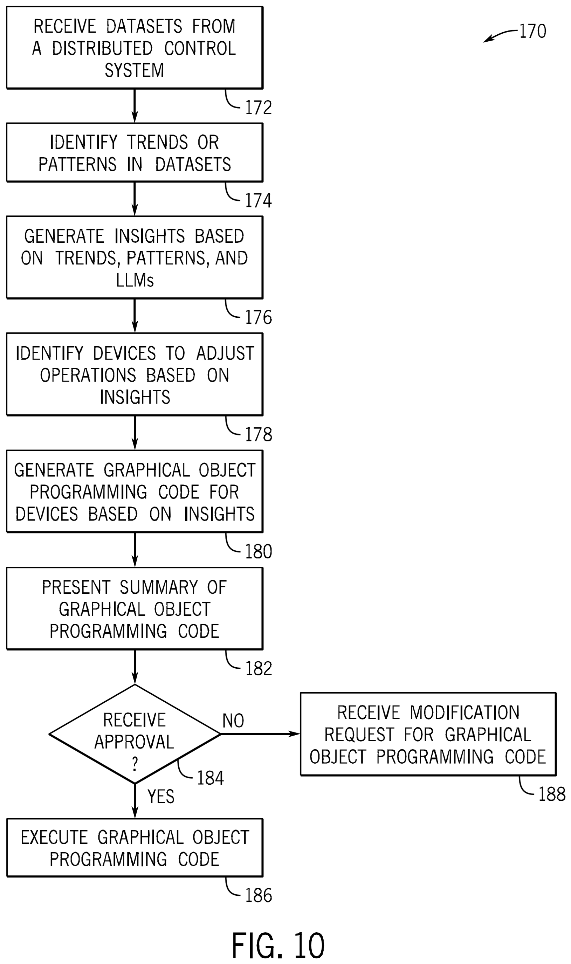

With this in mind, FIG. 10 illustrates a flow chart of a method 170 for generating real-time graphical object programming code based on real-time data analysis, in accordance with embodiments presented herein. Although the following description of the method 170 is described as being performed by the computing system 26 and in a particular order, it should be understood that the method 150 may be performed by any suitable computing system and in any suitable order.

Referring now to FIG. 9, at block 172, the computing system 26 may receive one or more datasets from the distributed control system 62, the sensors 28, or any other data source in the industrial system. The datasets may include real-time data acquired by respective sensors or devices. The datasets may include information related to power usage, temperature, vibration, production metrics (e.g., cycle times, throughput, defect rates), pressure, maintenance logs (e.g., failures, downtime, repair), energy consumption, scheduling data, and the like. Indeed, the datasets may relate to any suitable parameter that may be measured or generated by the control systems or sensors in the industrial system.

At block 174, the computing system 26 may identify trends or patterns that may be in the datasets. As such, the computing system 26 may use clustering algorithms to group datasets with similar characteristics. The computing system 26 may also perform time series analysis that may predict forecast demand, machine failures, production defects, and the like. In addition, the computing system 26 may use unsupervised learning methods (e.g., isolation forests, autoencoders) to detect anomalies related to the operations of the device, the system, and the like. The computing system 26 may employ machine learning models to find relationships based on correlations between datasets and may use predictive modeling techniques (e.g., regression model) to predict operational parameters for the devices, system, and the like.

Based on the trends and patterns identified by the computing system 26, at block 176, the computing system 26 may generate insights using the LLMs 60. That is, the LLMs 60 may include a model related to interpreting trend and pattern data with respect to various types of devices, industrial systems, and the like to provide a natural language description of the present state of the respective devices, system, and the like. Since the datasets received at block 152 correspond to real-time data, the insights generated at block 176 correspond to a real-time assessment of the respective devices or system with respect to the machine learning and predictive modeling outputs described above. The insights may include indications that a device or system is experiencing an anomaly (e.g., alarm, fault), expected to experience an anomaly within a threshold amount of time, operating inefficiently (e.g., power consumption, production rate) as compared to other systems, showing signs of mechanical wear (e.g., vibration data greater than threshold), and the like. As such, the insights may provide information related to potential issues that may prevent the respective device or system from performing its operations for a period of time.

After generating the insights, at block 178, the computing system 26 may identify one or more devices that may be related to the insights. That is, the computing system 26 may cross reference the information provided in the insights to devices that may contribute to any of the corresponding issues specified in the insights information. The devices may be identified based on a relationship between their respective operations and their effects on the corresponding issues. For example, if the insight information indicates that a particular portion of a system is experiencing a vibration measurement that exceeds a threshold level, the computing system 26 may identify the devices that may contribute to the vibration. In some embodiments, the computing system 26 may query an LLM trained on datasets related to the relationships between devices and corresponding portions of an industrial system, such as the locations of the devices with respect to the portions of the industrial system.

At block 180, the computing system 26 may generate graphical object programming code for the devices identified at block 178. That is, the graphical object programming code may be generated using any of the methods described above. In some embodiments, the computing system 26 may generate a prompt using the LLMs 60 and the insights to design updated graphical object programming code for the identified devices. As such, the computing system 26 may verify the generated graphical object programming code using test scripts or simulate the effects of the generated graphical object programming code as described above.

At block 182, the computing system 26 may present a summary of the graphical object programming code generated at block 180. As such, the computing system 26 may leverage the LLMs 60 to determine a characterization of the generated code. The summary may provide information related to the operational functions of the graphical object programming code, expected effects to one or more respective devices, expected effects to a corresponding system, expected effects to issues provided in the insights, and the like.

At block 184, the computing system 26 may determine whether it received approval of the graphical object programming code generated at block 180. If the approval is received, the computing system 26 may proceed to block 186 and execute the code. If, however, the computing system 26 does not receive approval, the computing system 26 may proceed to block 188 and receive a modification request for the graphical object programming code. The modification request may be processed via any of the processes described above.

By performing the method 170, the computing system 26 may monitor real-time data from the distributed control system 62 and other data sources to detect potential issues, assess current states of devices/systems, and determine real-time adjustments to operations of devices to prevent failure, perform predictive maintenance, and the like. Indeed, the real-time adjustments may be related to adjusting the load conditions (e.g., speed, frequency) for device outputs to ensure that the overall system is capable of being functional for a longer period of time. In addition, the computing system 26 may continuously monitor the operations of the devices and the system and compare the operations to updated control schemes, management techniques, and the like, which may be provided to the LLMs 60. In this way, the present embodiments may enable users to continuously improve the efficiencies in which devices operate, systems function, and the like as improved methodologies are discovered. In some embodiments, the method 170 may be performed in response to detecting an alarm, a fault, a measured value above a threshold, or the like. In this way, the user may be provided with relevant information related to resolving the detected issue, along with graphical object programming code that may be used to address the issue. By presenting the graphical object programming code to the user, the computing system 26 enables the user to better understand the control operations, as opposed to viewing raw code. In addition, the computing system 26 may provide inline input visualizations, as described above, to allow the user to provide requests and inquiries related to the generated code.

Although the foregoing description described performing various embodiments with respect to ladder logic, it should be understood that the present embodiments described herein may be implemented for any suitable graphical object programming code such as sequential function chart (SFC), function block diagram (FBD), and the like.

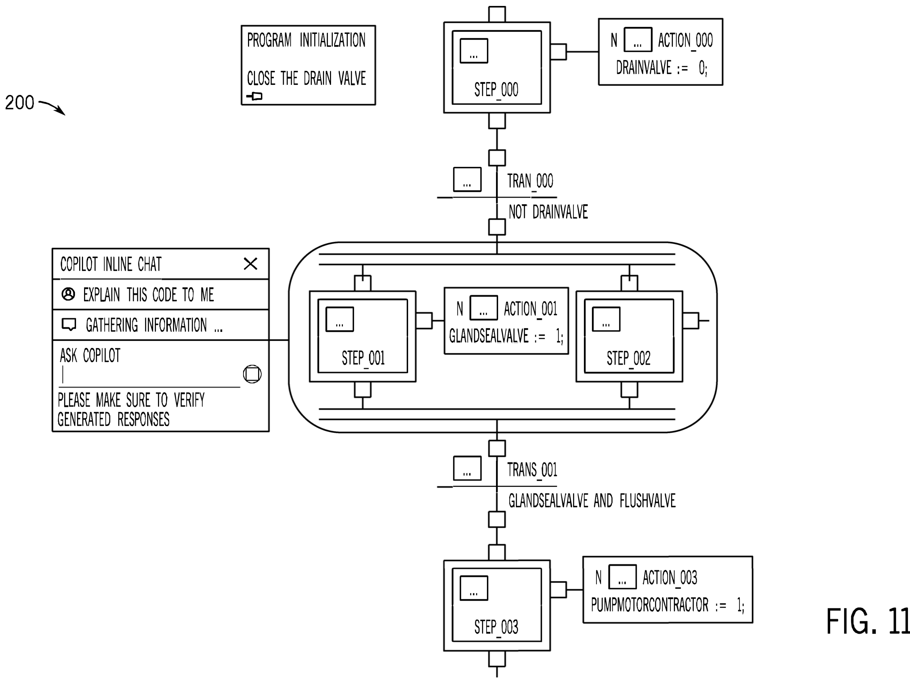

By way of example, FIG. 11 illustrates an example visualization 200 for generating graphical object programming code for sequential function chart (SFC), in accordance with aspects of the present disclosure. As shown in FIG. 11, the visualization 200 includes an input field to interact with the AI component, the LLMs, and the like to generate graphical code in the sequential function chart format. SFC may include a visual programming language for Programmable Logic Controllers (PLCs) or other control systems that may depict a process as a sequence of steps (e.g., states) and transitions between the steps that may be based on certain conditions for moving between the steps. SFC may include using graphical symbols to represent actions and control flow. In some embodiments, graphical symbols may include steps for representing stable states or actions within the control process; transitions for defining the conditions or events that trigger the move from one step to the next; directed links that may include arrows that show the flow between steps and transitions; branches that may allow for parallel (e.g., simultaneous) or alternative (e.g., conditional) paths in the process; and the like.

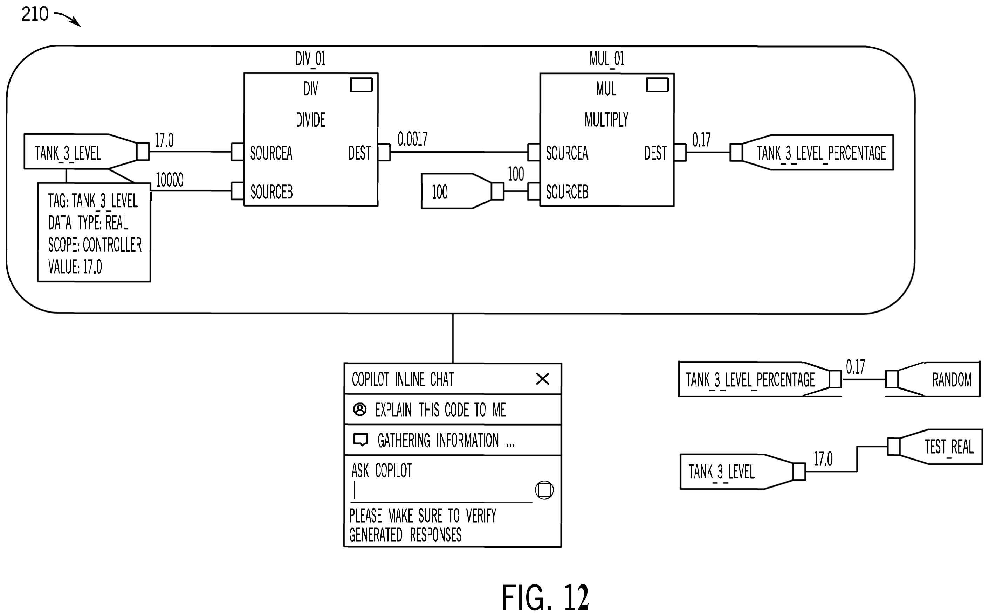

In the same manner, FIG. 12 illustrates an example visualization 210 for generating graphical object programming code for function block diagram (FBD), in accordance with aspects of the present disclosure. As shown in FIG. 12, the visualization 210 includes an input field to interact with the AI component, the LLMs, and the like to generate graphical code in the functional block diagram format. FBD may include a visual programming language for Programmable Logic Controllers (PLCs) or other control systems that may use function blocks and connection lines between them to represent the logic of a control system. In some embodiments, the function blocks may represent specific functions, such as arithmetic operations, counters, or timers, and may be linked together to form networks that execute sequentially to control a process.

Although portions of the present disclosure are described in the context of ladder logic and corresponding inline input visualizations that correspond to rungs of the ladder logic, it should be noted that the embodiments described herein with respect to the inline input visualization may also apply to the other automation graphical object programming codes, such as SFC and FBD. Indeed, though SFC and FBD may not employ rungs of code, these graphical object programming codes, along with others, may include graphical elements that may be placed, arranged, or repositioned in a user specified diagram space (e.g., two-dimensional) and the AI component may generate the appropriate graphical object programming code in the appropriate format based on the corresponding training of the respective LLMs.

By way of example, a user may interact with an input visualization to generate SFC graphical objects to create an SFC step and associate the step with a cluster of existing graphical elements similar to pointing and opening the inline input visualization described above on one or more existing rungs or associate the step with no elements similar to pointing and opening the inline input visualization to empty rung. As such, the inline input visualization for the SFC visualization may include some visual indication to associate it with one or more existing graphical elements similar to SFC lines connecting SFC steps.

Implementing FBD graphical object may include a similar process as described above. That is, the inline input visualization may be implemented to perform FBD instructions by employing a visual indication to associate the inline input visualization with one or more existing graphical elements associated with the FBD input and output connector lines.

In any case, the embodiments described herein may provide the ability to view a history of message conversations between the user and AI component, provide the ability to create new user messages, provide the ability to delete messages, enable the user to provide feedback, and the like. In addition, the graphical objects in any of the embodiments described herein may enable the user to move, resize, or reposition the graphical objects (e.g., SFC steps or FBD instructions), such that the user may work on/view other parts of diagram at same time while interacting with the inline input visualization. After the AI component makes any recommendation or change, the user may be provided to accept or reject those changes as described above. In some embodiments, the new or updated graphical objects may be presented in a different format to distinguish between the changes that have been accepted and rejected.

The present embodiments described herein provide the practical application of enabling users of industrial systems to implement graphical object programming code in a manner that provides for an improved user experience. Indeed, the design tools for generating graphical object programming code involves using complex interfaces that make it inefficient for users to access appropriate graphical objects in an efficient manner, much less generate the graphical object programming code in an efficient manner. By enabling the user to provide multi-modal inputs to generate graphical object programming code and leveraging the inputs against large language models that may have been trained on datasets associated with various relationships between graphical object programming code and issues corresponding to operating industrial systems, the present embodiments provide efficient programming tools that improve the processing efficiencies in determining solutions to various issues in the industrial system. Indeed, the AI component may use the trained LLMs to continuously improve the efficient identification of graphical object programming code to perform the various embodiments described herein. Further, the testing and simulations tools may help ensure that the resulting graphical object programming code may perform tasks efficiently without errors.

While only certain features have been illustrated and described herein, many modifications and changes will occur to those skilled in the art. It is, therefore, to be understood that the appended claims are intended to cover all such modifications and changes as fall within the true spirit of the disclosure.

The techniques presented and claimed herein are referenced and applied to material objects and concrete examples of a practical nature that demonstrably improve the present technical field and, as such, are not abstract, intangible or purely theoretical. Further, if any claims appended to the end of this specification contain one or more elements designated as "means for (perform)ing (a function)..." or "step for (perform)ing (a function)...", it is intended that such elements are to be interpreted under 35 U.S.C. 112(f). However, for any claims containing elements designated in any other manner, it is intended that such elements are not to be interpreted under 35 U.S.C. 112(f).
**The following is a list of further preferred embodiments of the invention:**
Embodiment 1. A method, comprising:
   receiving, via a processing system, a request to generate graphical object programming code via design environment comprising a plurality of lines for coding;
   presenting, via the processing system, an inline visualization corresponding a first line of the plurality of lines;
   receiving, via the processing system, an input comprising a natural language description of one or more operations for the graphical object programming code within the inline visualization;
   generating, via the processing system, the graphical object programming code within the inline visualization based on the input and one or more large language models (LLMs); and
   presenting, via the processing system, the graphical object programming code within the inline visualization.
Embodiment 2. The method of embodiment 1, wherein the graphical object programming code comprises ladder logic.
Embodiment 3. The method of embodiment 1, comprising:
   generating detail data comprising information related to the graphical object programming code in the inline visualization, wherein the detail data corresponds to a natural language format; and
   presenting the detail data within the inline visualization.
Embodiment 4. The method of embodiment 3, comprising:
   receiving an indication representative of an approval of the graphical object programming code; and
   executing the graphical object programming code.
Embodiment 5. The method of embodiment 1, comprising:
   receiving an indication representative of a modification to the graphical object programming code via the inline visualization; and
   generating updated graphical object programming code based on the indication.
Embodiment 6. The method of embodiment 5, comprising:
   performing a simulation of the updated graphical object programming code via an emulator;
   generating one or more additional recommendations for modifying the updated graphical object programming code based on the simulation;
   generating additional graphical object programming code based on the one or more additional recommendations.
Embodiment 7. The method of embodiment 6, comprising executing the additional graphical object programming code by sending the graphical object programming code to an industrial device.
Embodiment 8. A non-transitory computer-readable medium comprising computer-executable instructions that, when executed, cause a processing system to perform operations comprising:
   receiving a request to generate graphical object programming code via design environment comprising a plurality of lines for coding;
   presenting an inline visualization corresponding a first line of the plurality of lines;
   receiving an input comprising a natural language description of one or more operations for the graphical object programming code within the inline visualization;
   generating the graphical object programming code within the inline visualization based on the input and one or more large language models (LLMs); and
   presenting the graphical object programming code within the inline visualization.
Embodiment 9. The non-transitory computer-readable medium of embodiment 8, wherein the graphical object programming code comprises ladder logic.
Embodiment 10. The non-transitory computer-readable medium of embodiment 8, wherein the computer-executable instructions cause the processing system to perform additional operations comprising:
   generating detail data comprising information related to the graphical object programming code in the inline visualization, wherein the detail data corresponds to a natural language format; and
   presenting the detail data within the inline visualization.
Embodiment 11. The non-transitory computer-readable medium of embodiment 10, wherein the computer-executable instructions cause the processing system to perform additional operations comprising:
   receiving an indication representative of an approval of the graphical object programming code; and
   executing the graphical object programming code.
Embodiment 12. The non-transitory computer-readable medium of embodiment 8, wherein the computer-executable instructions cause the processing system to perform additional operations comprising:
   receiving an indication representative of a modification to the graphical object programming code via the inline visualization; and
   generating updated graphical object programming code based on the indication.
Embodiment 13. The non-transitory computer-readable medium of embodiment 12, wherein the computer-executable instructions cause the processing system to perform additional operations comprising:
   performing a simulation of the updated graphical object programming code via an emulator;
   generating one or more additional recommendations for modifying the updated graphical object programming code based on the simulation; and
   generating additional graphical object programming code based on the one or more additional recommendations.
Embodiment 14. The non-transitory computer-readable medium of embodiment 13, wherein the additional operations comprise executing the additional graphical object programming code by sending the graphical object programming code to an industrial device.
Embodiment 15. A system, comprising:
   a plurality of large language models (LLMs); and
   a computing system comprising computer-executable instructions that, when executed, cause the computing system to perform operations comprising:
   receiving a request to generate graphical object programming code via design environment comprising a plurality of lines for coding;
   presenting an inline visualization corresponding a first line of the plurality of lines;
   receiving an input comprising a natural language description of one or more operations for the graphical object programming code within the inline visualization;
   generating the graphical object programming code within the inline visualization based on the input and one or more large language models (LLMs); and
   presenting the graphical object programming code within the inline visualization.
Embodiment 16. The system of embodiment 15, wherein the graphical object programming code comprises ladder logic.
Embodiment 17. The system of embodiment 15, wherein the computer-executable instructions cause the computing system to perform additional operations comprising:
   generating detail data comprising information related to the graphical object programming code in the inline visualization, wherein the detail data corresponds to a natural language format; and
   presenting the detail data within the inline visualization.
Embodiment 18. The system of embodiment 15, wherein the computer-executable instructions cause the computing system to perform additional operations comprising:
   receiving an indication representative of an approval of the graphical object programming code; and
   executing the graphical object programming code.
Embodiment 19. The system of embodiment 15, wherein the computer-executable instructions cause the computing system to perform additional operations comprising:
   receiving an indication representative of a modification to the graphical object programming code via the inline visualization; and
   generating updated graphical object programming code based on the indication.
Embodiment 20. The system of embodiment 19, wherein the computer-executable instructions cause the processing system to perform additional operations comprising:
   performing a simulation of the updated graphical object programming code via an emulator;
   generating one or more additional recommendations for modifying the updated graphical object programming code based on the simulation; and
   generating additional graphical object programming code based on the one or more additional recommendations.

## Claims

1. A method, comprising:
receiving, via a processing system, a request to generate graphical object programming code via design environment comprising a plurality of lines for coding;
presenting, via the processing system, an inline visualization corresponding a first line of the plurality of lines;
receiving, via the processing system, an input comprising a natural language description of one or more operations for the graphical object programming code within the inline visualization;
generating, via the processing system, the graphical object programming code within the inline visualization based on the input and one or more large language models (LLMs); and
presenting, via the processing system, the graphical object programming code within the inline visualization.

2. The method of claim 1, at least one of:
wherein the graphical object programming code comprises ladder logic; and
the method comprising:
generating detail data comprising information related to the graphical object programming code in the inline visualization, wherein the detail data corresponds to a natural language format; and
presenting the detail data within the inline visualization,
the method preferably further comprising:
receiving an indication representative of an approval of the graphical object programming code; and
executing the graphical object programming code.

3. The method of claim 1 or 2, comprising:
receiving an indication representative of a modification to the graphical object programming code via the inline visualization; and
generating updated graphical object programming code based on the indication.

4. The method of claim 3, comprising:
performing a simulation of the updated graphical object programming code via an emulator;
generating one or more additional recommendations for modifying the updated graphical object programming code based on the simulation;
generating additional graphical object programming code based on the one or more additional recommendations,
the method preferably further comprising executing the additional graphical object programming code by sending the graphical object programming code to an industrial device.

5. A non-transitory computer-readable medium comprising computer-executable instructions that, when executed, cause a processing system to perform operations comprising:
receiving a request to generate graphical object programming code via design environment comprising a plurality of lines for coding;
presenting an inline visualization corresponding a first line of the plurality of lines;
receiving an input comprising a natural language description of one or more operations for the graphical object programming code within the inline visualization;
generating the graphical object programming code within the inline visualization based on the input and one or more large language models (LLMs); and
presenting the graphical object programming code within the inline visualization.

6. The non-transitory computer-readable medium of claim 5, wherein the graphical object programming code comprises ladder logic.

7. The non-transitory computer-readable medium of claim 5 or 6, wherein the computer-executable instructions cause the processing system to perform additional operations comprising:
generating detail data comprising information related to the graphical object programming code in the inline visualization, wherein the detail data corresponds to a natural language format; and
presenting the detail data within the inline visualization.

8. The non-transitory computer-readable medium of claim 7, wherein the computer-executable instructions cause the processing system to perform additional operations comprising:
receiving an indication representative of an approval of the graphical object programming code; and
executing the graphical object programming code.

9. The non-transitory computer-readable medium of one of claims 5 to 8, wherein the computer-executable instructions cause the processing system to perform additional operations comprising:
receiving an indication representative of a modification to the graphical object programming code via the inline visualization; and
generating updated graphical object programming code based on the indication.

10. The non-transitory computer-readable medium of claim 9, wherein the computer-executable instructions cause the processing system to perform additional operations comprising:
performing a simulation of the updated graphical object programming code via an emulator;
generating one or more additional recommendations for modifying the updated graphical object programming code based on the simulation; and
generating additional graphical object programming code based on the one or more additional recommendations,
wherein preferably the additional operations comprise executing the additional graphical object programming code by sending the graphical object programming code to an industrial device.

11. A system, comprising:
a plurality of large language models (LLMs); and
a computing system comprising computer-executable instructions that, when executed, cause the computing system to perform operations comprising:
receiving a request to generate graphical object programming code via design environment comprising a plurality of lines for coding;
presenting an inline visualization corresponding a first line of the plurality of lines;
receiving an input comprising a natural language description of one or more operations for the graphical object programming code within the inline visualization;
generating the graphical object programming code within the inline visualization based on the input and one or more large language models (LLMs); and
presenting the graphical object programming code within the inline visualization.

12. The system of claim 11, wherein the graphical object programming code comprises ladder logic.

13. The system of claim 11 or 12, at least one of:
wherein the computer-executable instructions cause the computing system to perform additional operations comprising:
generating detail data comprising information related to the graphical object programming code in the inline visualization, wherein the detail data corresponds to a natural language format; and
presenting the detail data within the inline visualization; and
wherein the computer-executable instructions cause the computing system to perform additional operations comprising:
receiving an indication representative of an approval of the graphical object programming code; and
executing the graphical object programming code.

14. The system of one of claims 11 to 13, wherein the computer-executable instructions cause the computing system to perform additional operations comprising:
receiving an indication representative of a modification to the graphical object programming code via the inline visualization; and
generating updated graphical object programming code based on the indication.

15. The system of claim 14, wherein the computer-executable instructions cause the processing system to perform additional operations comprising:
performing a simulation of the updated graphical object programming code via an emulator;
generating one or more additional recommendations for modifying the updated graphical object programming code based on the simulation; and
generating additional graphical object programming code based on the one or more additional recommendations.
